**Europäisches Patentamt**

**European Patent Office**

**Office européen des brevets**

(11) Veröffentlichungsnummer: **0 107 028**
**B1**

(12) **EUROPÄISCHE PATENTSCHRIFT**

(45) Veröffentlichungstag der Patentschrift:
18.01.89

(21) Anmeldenummer: **83109227.5**

(22) Anmeldetag: **17.09.83**

(51) Int. Cl.⁴: **H 03 K 17/08**

(54) Schaltungsanordnung mit einer Ausgangstransistorschaltung und einer Schutzschaltung zur Begrenzung des Ausgangsstroms der Ausgangstransistorschaltung.

(30) Priorität: **21.10.82 DE 3238880**

(43) Veröffentlichungstag der Anmeldung:
**02.05.84 Patentblatt 84/18**

(45) Bekanntmachung des Hinweises auf die Patenterteilung:
**18.01.89 Patentblatt 89/3**

(84) Benannte Vertragsstaaten:
**DE FR GB**

(56) Entgegenhaltungen:
**WO-A-82/01105**
**FR-A- 2 301 948**
**GB-A- 2 042 297**
**US-A- 3 792 316**
**US-A- 4 359 652**

**ELECTRONICS, Band 47, Nr. 3, 7. Februar 1974, Seiten 119-123, New York, US; R.C. DOBKIN: "IC with load protection simulates power transistor"**

(73) Patentinhaber: **ROBERT BOSCH GMBH, Postfach 50, D-7000 Stuttgart 1 (DE)**

(72) Erfinder: **Kalkhof, Bernd, Dipl.-Ing., Am Rosenbach 10, D-7410 Reutlingen 28 (DE)**
Erfinder: **Nagel, Karl, Grundstrasse 24, D-7419 Gomaringen (DE)**

## Beschreibung

### Stand der Technik

Die Erfindung betrifft eine Schaltungsanordnung nach der Gattung des Patentanspruchs 1.

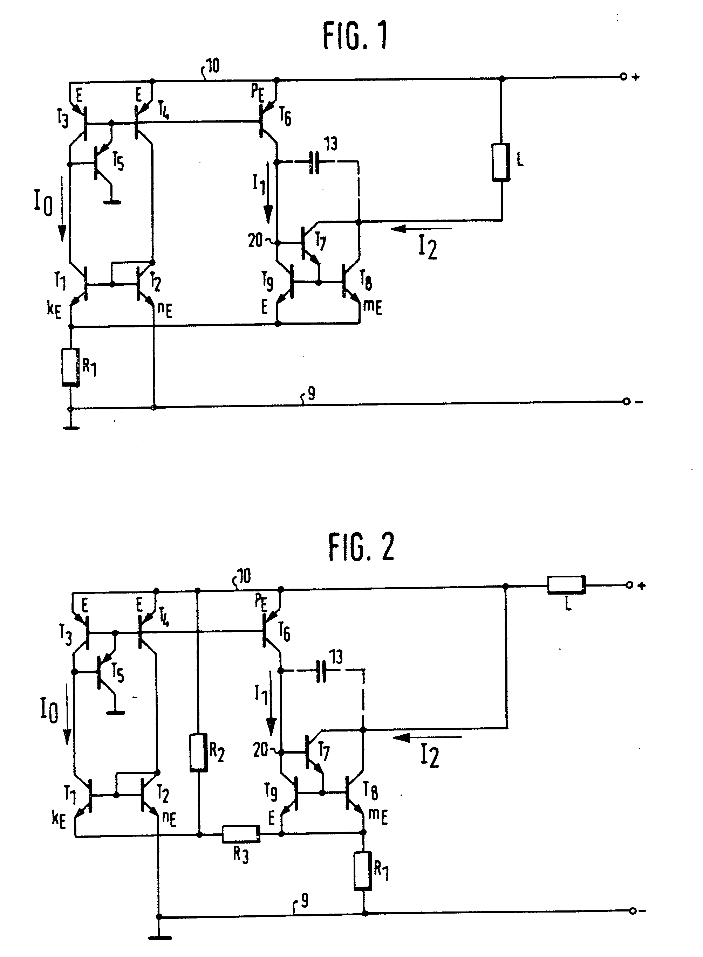

Aus dem Aufsatz von R.C. Dobkin «IC with load protection simulates power transistor» aus der Zeitschrift Electronics, Band 47, Nr. 3 vom 07. 02. 1974, Figur 1, Seite 119 ist bereits eine Schaltungsanordnung dieser Art bekannt, bei der die Ausgangstransistorschaltung als Darlingtonschaltung mit einem ersten und einem zweiten Transistor ausgebildet ist, wobei der erste Transistor als Endtransistor und der zweite Transistor als Vortransistor dient. Wird bei dieser bekannten Schaltungsanordnung im Störfall die Last kurzgeschlossen, so wird mit Hilfe der Schutzschaltung der durch den Endtransistor fliessende Ausgangsstrom begrenzt. Der Genauigkeit der Stromübersetzung der als Darlingtonschaltung ausgebildeten Ausgangstransistorschaltung und damit der Genauigkeit der Begrenzung des durch den Endtransistor fliessenden Ausgangsstroms sind jedoch dabei Grenzen gesetzt.

### Vorteile der Erfindung

Die erfindungsgemässe Schaltungsanordnung mit den kennzeichnenden Merkmalen des Patentanspruchs 1 hat demgegenüber den Vorteil, dass durch die Ausbildung der Ausgangstransistorschaltung als Stromspiegelschaltung die Genauigkeit der Stromübersetzung und damit die Genauigkeit der Begrenzung des Ausgangsstroms erhöht wird.

Weitere Vorteile ergeben sich aus den Unteransprüchen 2 bis 4 und aus der Beschreibung.

### Zeichnung

Vier Ausführungsbeispiele der erfindungsgemässen Schaltungsanordnung sind in der Zeichnung dargestellt und in der nachfolgenden Beschreibung näher erläutert. Die Figuren 1 bis 4 zeigen je eines der Ausführungsbeispiele.

### Beschreibung der Ausführungsbeispiele

In Figur 1 ist eine Schaltungsanordnung mit einer Ausgangstransistorschaltung dargestellt, die zwei npn-Transistoren $T_7$, $T_8$ enthält, die in Darlingtonschaltung miteinander verbunden sind. Der gemeinsame Kollektor der beiden Transistoren $T_7$, $T_8$ liegt an dem einen Ende einer Last L, deren anderes Ende an die Plusklemme einer Batterie angeschlossen ist. Der Emitter des Transistors $T_8$ ist über einen ohmschen Widerstand $R_1$ mit der Minusklemme der Batterie verbunden. An einen Steueranschluss 20 der Ausgangstransistorschaltung, die die Transistoren $T_7$, $T_8$ enthält, ist eine in der Zeichnung nicht dargestellte Steuerschaltung gelegt, die beim normalen Betrieb der Schaltungsanordnung zur Ansteuerung der Ausgangstransistorschaltung dient.

Der zwischen dem Emitter des Transistors $T_8$ und der Minusklemme der Batterie liegende ohmsche Widerstand $R_1$ bildet die Regelstrecke einer von der Versorgungsspannung unabhängigen, an sich bekannten, als Ringstromquelle ausgebildeten Bezugsstromquelle, die zwischen einer positiven Betriebsstromleitung 10 und einer negativen Betriebsstromleitung 9 angeordnet ist. Die positive Betriebsstromleitung 10 ist hierbei an die Plusklemme der Batterie und die negative Betriebsstromleitung 9 an die Minusklemme der Batterie angeschlossen. Der Auskoppelstrom $I_1$ der Bezugsstromquelle wird dem Steueranschluss 20 der Ausgangstransistorschaltung zugeführt.

Erfindungsgemäss ist ein npn-Transistor $T_9$ vorgesehen, dessen Emitter-Basis-Strecke parallel zur Emitter-Basis-Strecke des Transistors $T_8$ liegt und dessen Kollektor an die Basis 20 des Transistors $T_7$ angeschlossen ist. Der Transistor $T_9$ bildet zusammen mit den Transistoren $T_7$, $T_8$ eine die Ausgangstransistorschaltung bildende Stromspiegelschaltung, deren Eingang durch den Kollektor des Transistors $T_9$ und deren Ausgang durch den Kollektor des Transistors $T_8$ gebildet wird, wobei der Vortransistor $T_7$ der Darlingtonschaltung als Basisstromverstärker der Stromspiegelschaltung wirkt. Die Emitterfläche des Transistors $T_9$ ist dabei mit E bezeichnet. Der Transistor $T_8$ kann eine von der Fläche E verschiedene Emitterfläche mE haben, wobei m vorzugsweise grösser als Eins ist.

Die als Ringstromquelle ausgebildete Bezugsstromquelle kann aus den Transistoren $T_1$, $T_2$, $T_3$, $T_4$, $T_5$, $T_6$ bestehen, wobei die Transistoren $T_1$ und $T_2$ als npn-Transistoren und die Transistoren $T_3$, $T_4$, $T_5$, $T_6$ als pnp-Transistoren ausgebildet sind. Die Transistoren $T_1$ bis $T_6$ sind dabei wie im folgenden beschrieben zusammengeschaltet: Der Transistor $T_3$ ist mit seinem Emitter an die positive Betriebsstromleitung 10 und mit seinem Kollektor an den Kollektor des Transistors $T_1$ angeschlossen, während seine Basis an die Basen der Transistoren $T_4$ und $T_6$ angeschlossen ist. Der Emitter des Transistors $T_3$ hat die Fläche E, der Emitter des Transistors $T_4$ ist an die Betriebsstromleitung 10, sein Kollektor an den Kollektor des Transistors $T_2$ angeschlossen. Der Transistor $T_4$ hat die Emitterfläche E. Die Basen der Transistoren $T_3$ und $T_4$ sind über die Emitter-Basis-Strecke des Transistors $T_5$ mit dem Kollektor des Transistors $T_3$ verbunden, wobei der Kollektor des Transistors $T_5$ an die negative Betriebsstromleitung 9 angeschlossen ist. Die Transistoren $T_3$, $T_4$, $T_5$ wirken dabei als Stromspiegel, wobei der Transistor $T_5$ als Basisstromverstärker dient. Der Emitter des Transistors $T_1$ hat die Emitterfläche kE und ist über den Widerstand $R_1$ an die negative Betriebsstromleitung 9 angeschlossen, während seine Basis an die Basis und an den Kollektor des Transistors $T_2$ angeschlossen ist. Der Emitter des Transistors $T_2$ hat die Fläche nE und ist an die negative Betriebsstromleitung 9 angeschlossen. Zur Bereitstellung des Auskoppelstroms $I_1$ der Bezugsstromquelle dient der Auskoppeltransistor $T_6$, dessen Emitter die Fläche pE hat und an die positive Betriebsstromleitung 10 angeschlossen ist, während der Kollektor des Transistors $T_6$ den Auskoppelstrom $I_1$ liefert und an den Steueranschluss 20 der Aus-

gangstransistorschaltung $T_7$, $T_8$, $T_9$ angeschlossen ist.

Darüber hinaus ist der Kollektor des Transistors $T_6$ über eine Kapazität 13 mit dem Kollektor des Transistors $T_8$ verbunden.

Wenn die Stromverstärkungen der pnp-Transistoren und der npn-Transistoren beide gross gegenüber Eins sind, dann erzwingt der aus den Transistoren $T_3$, $T_4$ und $T_5$ bestehende Stromspiegel Stromgleichheit. Es gilt dann für die Flussspannungen der Transistoren $T_1$ und $T_2$:

$$(1) \qquad U_{BE1} = U_T \cdot \ln \frac{I_o}{k \cdot I_S} \text{ und}$$

$$(2) \qquad U_{BE2} = U_T \cdot \ln \frac{I_o}{n \cdot I_S},$$

wobei $U_T = \frac{K}{q} T$ die Temperaturspannung, K die Boltzmannkonstante, q die Elementarladung, T die absolute Temperatur und $I_S$ der Sättigungsstrom ist. Der Spannungsabfall am Widerstand $R_1$ ist:

$$(3) \qquad U_{R1} = R_1 \cdot (I_0 + I_1 + I_2).$$

Dabei ist

$$(4) \qquad I_1 = m \cdot I_0$$

$$(5) \qquad I_2 = p \cdot I_1.$$

Der Spannungsumlauf an den Schaltungselementen $T_1$, $T_2$ und $R_1$ ergibt:

$$(6) \qquad U_{R1} = U_{BE2} - U_{BE1}.$$

Durch Einsetzen der Werte aus den Gleichungen (1) bis (5) in Gleichung (6) erhält man:

$$(7) \qquad I_2 = \frac{U_T}{R_1} \cdot \frac{1}{1 + \frac{1}{P} + \frac{1}{mp}} \cdot \ln \frac{k}{n}.$$

Durch die anhand der Figur 1 beschriebenen Schaltungsmassnahmen wird also der über die Emitter-Kollektor-Strecke des Transistors $T_8$ im Kurzschlussfall fliessende Ausgangsstrom $I_2$ unter Einbeziehung des dritten Transistors $T_9$ auf den in Gleichung (7) angegebenen Wert begrenzt, wobei $U_T$, wie oben angegeben, die Temperaturspannung ist. In der Praxis werden m und p gross sein, um grössere Ausgangsströme zu erreichen.

Die Temperaturspannung $U_T$ ist proportional zur absoluten Temperatur. Der Temperaturkoeffizient beträgt dabei +3,3‰/K. Wählt man für den Widerstand $R_1$ einen Widerstand mit demselben Temperaturkoeffizienten, so wird die Anordnung temperaturkompensiert. Günstiger ist noch, den Temperaturkoeffizienten des Widerstandes $R_1$ grösser als den Temperaturkoeffizienten der Temperaturspannung $U_T$ zu wählen, um mit steigender Temperatur einen kleiner werdenden Ausgangsstrom, d.h. auch eine geringere Verlustleistung zu erhalten. Hier bietet sich ein Metallwiderstand mit einem Temperaturkoeffizienten von 3,9‰/K an.

Beim Ausführungsbeispiel nach Figur 2 ist die positive Betriebsstromleitung 10 abweichend vom Ausführungsbeispiel nach Figur 1 an den Kollektor des Transistors $T_8$ angeschlossen, der seinerseits über die Last L mit der Plusklemme der Batterie verbunden ist. Die Bezugsstromquelle liegt wieder zwischen der positiven Betriebsstromleitung 10 und der negativen Betriebsstromleitung 9. Der Widerstand $R_1$ liegt zwischen dem Emitter des Transistors $T_8$ und der negativen Betriebsstromleitung 9. Die aneinander angeschlossenen Emitter der beiden Transistoren $T_8$ und $T_9$ sind über einen Widerstand $R_3$ mit dem Emitter des Transistors $T_1$ verbunden, während vom Emitter des Transistors $T_1$ ein Widerstand $R_2$ zur positiven Betriebsstromleitung 10 führt. Durch die Einfügung der Widerstände $R_2$ und $R_3$ wird gegenüber dem Ausführungsbeispiel nach Figur 1 eine Verkleinerung des durch die Last L fliessenden Stroms in Abhängigkeit von der zwischen den beiden Betriebsstromleitungen 9 und 10 liegenden Spannung erreicht.

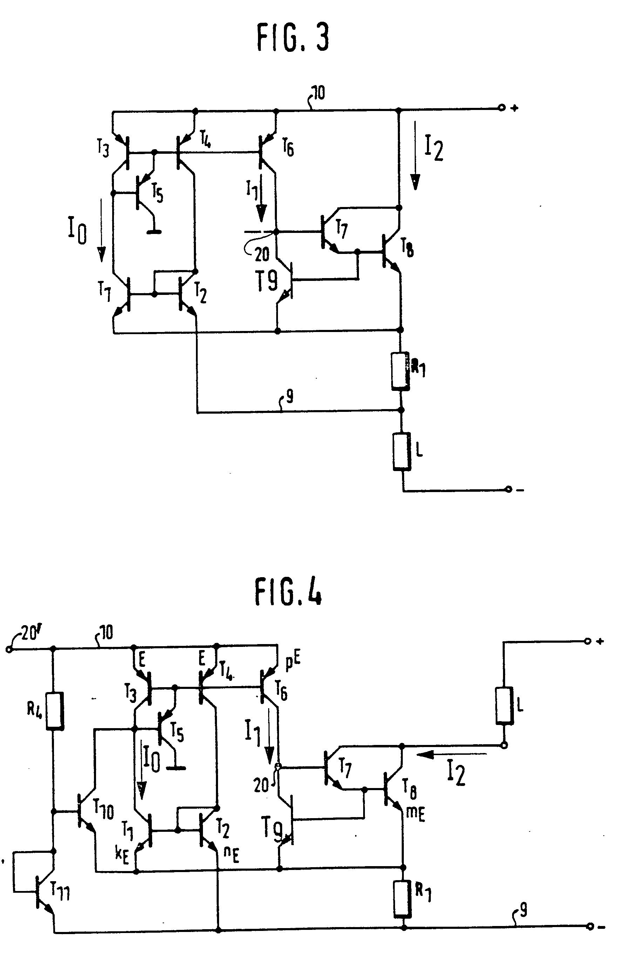

Figur 3 zeigt eine weitere Variante einer erfindungsgemässen Schaltungsanordnung. Der Aufbau entspricht weitgehend dem Ausführungsbeispiel nach den Figuren 1 und 2. Jedoch liegt die Last L in der Emitterzuleitung des Transistors $T_8$, während dessen Kollektor an der positiven Batterieklemme liegt, an die die positive Betriebsstromleitung 10 unmittelbar angeschlossen ist. Die Regelstrecke $R_1$ der Bezugsstromquelle liegt zwischen dem Emitter des Transistors $T_8$ und der Last L, wobei die negative Betriebsstromleitung 9 an die von der Regelstrecke $R_1$ zur Last L führende Verbindungsleitung angeschlossen ist.

Beim Ausführungsbeispiel nach Figur 4 ist im Gegensatz zu den Ausführungsbeispielen nach den Figuren 1 bis 3 das Potential der ersten Betriebsstromleitung 10 der Bezugsstromquelle nicht von dem Potential der Plusklemme der Batterie abgeleitet. Vielmehr ist dort die Betriebsstromleitung 10 von der Plusklemme der Batterie abgetrennt und statt dessen an einen äusseren Anschluss 20' angeschlossen, der als Steueranschluss der gesamten Schaltungsanordnung dient und anstelle des Anschlusses 20 als «Basis» der Ausgangstransistorschaltung $T_7$, $T_8$, $T_9$ wirkt. Diesem Anschluss 20' wird bei diesem Ausführungsbeispiel das dem Steueranschluss 20 der Ausgangstransistorschaltung $T_7$, $T_8$, $T_9$ zuzuführende, zur Ansteuerung dieser Schaltung dienende Steuersignal zugeführt. Die gesamte Schaltungsanordnung wirkt deshalb als modifizierter Darlingtontransistor.

Beim Ausführungsbeispiel nach Figur 4 ist ferner eine zum Anlaufen der Bezugsstromquelle dienende Anlaufschaltung vorgesehen, die aus den Schaltelementen $T_{10}$, $T_{11}$ und $R_4$ besteht.

**Patentansprüche**

1. Schaltungsanordnung mit einer Ausgangstransistorschaltung und einer Schutzschaltung zur Begrenzung des Ausgangsstroms der Ausgangstransistorschaltung, wobei die Ausgangstransistorschaltung mit ihrer Schaltstrecke in Reihe zu einer Last (L) und in Reihe zu einem ersten ohmschen Widerstand (R₁) liegt und die äusseren Enden dieser Reihenschaltung mit einer ersten und einer zweiten Batterieklemme (+ bzw. –) verbunden sind, mit einer zwischen einer ersten Betriebsstromleitung (10) und einer zweiten Betriebsstromleitung (9) angeordneten Bezugsstromquelle (T₁ bis T₆, R₁) mit einem von der Versorgungsspannung unabhängigen, einem Steueranschluss (20) der Ausgangstransistorschaltung zugeführten Auskoppelstrom (I₁), der durch den als Regelstrecke dienenden ersten ohmschen Widerstand (R₁) einstellbar ist, wobei die Ausgangstransistorschaltung einen ersten Transistor (T₈) und einen zweiten Transistor (T₇) vom gleichen Leitungstyp wie der erste Transistor (T₈) enthält, wobei der Kollektor des zweiten Transistors (T₇) an den Kollektor des ersten Transistors (T₈) und der Emitter des zweiten Transistors (T₇) an die Basis des ersten Transistors (T₈) angeschlossen ist und die Basis des zweiten Transistors (T₇) den Steueranschluss (20) der Ausgangstransistorschaltung bildet, dadurch gekennzeichnet, dass die Ausgangstransistorschaltung einen dritten Transistor (T₉) enthält, der den gleichen Leitungstyp wie der erste (T₈) und der zweite Transistor (T₇) hat und dessen Emitter-Basis-Strecke parallel zur Emitter-Basis-Strecke des ersten Transistors (T₈) liegt und dessen Kollektor an die Basis des zweiten Transistors (T₇) angeschlossen ist, so dass die drei genannten Transistoren (T₇, T₈, T₉) der Ausgangstransistorschaltung einen Stromspiegel bilden, dessen Eingang durch die Basis (20) des zweiten Transistors (T₇) und dessen Ausgang durch die miteinander verbundenen Kollektoren des ersten (T₈) und des zweiten Transistors (T₇) gebildet wird.

2. Schaltungsanordnung nach Anspruch 1, dadurch gekennzeichnet, dass zwischen den Eingang (20) und den Ausgang des Stromspiegels (T₇, T₈, T₉) ein Kondensator (13) gelegt ist.

3. Schaltungsanordnung nach Anspruch 1 oder 2, dadurch gekennzeichnet, dass die erste Betriebsstromleitung (10) mit der ersten Batterieklemme (+) und die zweite Betriebsstromleitung (9) mit der zweiten Batterieklemme (–) verbunden ist.

4. Schaltungsanordnung nach Anspruch 1 oder 2, dadurch gekennzeichnet, dass das Potential der ersten Betriebsstromleitung (10) durch das einem Steueranschluss (20') der Schaltungsanordnung zuführbare Steuerpotential gebildet wird, das über die Bezugsstromquelle (T₁ bis T₆, R₁) in den Steueranschluss (20) der Ausgangstransistorschaltung (T₇, T₈, T₉) einkoppelbar ist, und dass die zweite Betriebsstromleitung (9) mit der zweiten Batterieklemme (–) verbunden ist.

**Claims**

1. Circuit arrangement having an output transistor circuit and a protection circuit for limiting the output current of the output transistor circuit, the output transistor circuit switching path being located in series with a load (L) and in series with a first ohmic resistor (R₁) and the outer ends of this series circuit being connected to a first and a second battery terminal (+ and – respectively), having a reference current source (T₁ to T₆, R₁), which is arranged between a first operating current line (10) and a second operating current line (9), with an output current (I₁) which is independent of the supply voltage and which is supplied to a control connection (20) of the output transistor circuit and which can be adjusted by the first ohmic resistor (R₁) which is used as control element, the output transistor circuit containing a first transistor (T₈) and a second transistor (T₇) of the same type of conduction as the first transistor (T₈), in which arrangement the collector of the second transistor (T₇) is connected to the collector of the first transistor (T₈) and the emitter of the second transistor (T₇) is connected to the base of the first transistor (T₈) and the base of the second transistor (T₇) forms the control connection (20) of the output transistor circuit, characterized in that the output transistor circuit contains a third transistor (T₉) which has the same type of conduction as the first (T₈) and the second transistor (T₇) and the base-emitter path of which is parallel to the base-emitter path of the first transistor (T₈) and the collector of which is connected to the base of the second transistor (T₇), so that the three said transistors (T₇, T₈, T₉) of the output transistor circuit form a current balancing circuit, the input of which is formed by the base (20) of the second transistor (T₇) and the output of which is formed by the collectors, which are connected to one another, of the first (T₈) and of the second transistor (T₇).

2. Circuit arrangement according to Claim 1, characterized in that a capacitor (13) is placed between the input (20) and the output of the current balancing circuit (T₇, T₈, T₉).

3. Circuit arrangement according to Claim 1 or 2, characterized in that the first operating current line (10) is connected to the first battery terminal (+) and the second operating current line (9) is connected to the second battery terminal (–).

4. Circuit arrangement according to Claim 1 or 2, characterized in that the potential of the first operating current line (10) is formed by the control potential, which can be supplied to a control connection (20') of the circuit arrangement and which can be coupled into the control connection (20) of the output transistor circuit (T₇, T₈, T₉) via the reference current source (T₁ to T₆, R₁), and that the second operating current line (9) is connected to the second battery terminal (–).

**Revendications**

1. Montage de circuit avec un circuit à transistor de sortie et un circuit de protection pour limiter le courant de sortie du circuit à transistor de sortie, le circuit à transistor de sortie étant à cette occasion placé avec son tronçon de circuit en série avec une charge (L) et en série avec une première résistance ohmique (R₁) et les extrémités extérieures de ce circuit en série étant reliées à une première et à une deuxième borne de batterie (+, respectivement −), avec une source de courant de référence (T₁ à T₆, R₁) disposée entre une première ligne de courant de fonctionnement (9) et une deuxième ligne de courant de fonctionnement (10), avec un courant de couplage (I₁) indépendant de la tension d'alimentation, amené à un raccordement de commande (20) du circuit à transistor de sortie, courant qui est susceptible d'être réglé par une première résistance ohmique (R₁) servant de tronçon de régulation, le circuit à transistor de sortie possédant à cette occasion un premier transistor (T₈) et un deuxième transistor (T₇), qui est de même type de conduction que le premier transistor (T₈), le collecteur du deuxième transistor (T₇) étant à cette occasion raccordé au collecteur du premier transistor (T₈), et l'émetteur du deuxième transistor (T₇) étant à cette occasion raccordé à la base du premier transistor (T₈), et la base du premier transistor (T₈) formant le raccordement de commande (20) du circuit à transistor de sortie, caractérisé en ce que le circuit à transistor de sortie contient un troisième transistor (T₉) qui procède du même type de conduction que le premier transistor (T₈) et le deuxième transistor (T₇) et dont le tronçon émetteur-base est situé en parallèle au tronçon émetteur-base du premier transistor (T₈) et dont le collecteur est raccordé à la base du deuxième transistor (T₇), de sorte que les trois transistors évoqués (T₇, T₈, T₉) du circuit à transistor de sortie forment un réflecteur de courant dont l'entrée est formée par la base (20) du deuxième transistor (T₇) et dont la sortie est formée par les collecteurs reliés entre eux du premier transistor (T₈) et du deuxième transistor (T₇).

2. Montage de circuit selon la revendication 1, caractérisé en ce qu'un condensateur (13) est placé entre l'entrée (20) et la sortie du système réflecteur de courant (T₇, T₈, T₉).

3. Montage de circuit selon la revendication 1 ou 2, caractérisé en ce que la première ligne de courant de fonctionnement (10) est reliée à la première borne de batterie (+) et que la deuxième ligne de courant de fonctionnement (9) est reliée à la deuxième borne de batterie (−).

4. Montage de circuit selon la revendication 1 ou 2, caractérisé en ce que le potentiel de la première ligne de courant de fonctionnement (10) est formé au moyen du potentiel de commande susceptible d'être amené à un raccordement de commande (20') du montage de circuit, potentiel de commande qui est susceptible d'être couplé par la source de courant de référence (T₁ à T₆, R₁) dans le raccordement de commande (20) du circuit de transistor de sortie (T₇, T₈, T₉), et en ce que la deuxième ligne de courant de fonctionnement (9) est reliée à la deuxième borne de batterie (−).

# FIG. 1

# FIG. 2

# FIG. 3

# FIG. 4